(19) Europäisches Patentamt
European Patent Office
Office européen des brevets

(11) **EP 3 311 096 B1**

(12) **EUROPÄISCHE PATENTSCHRIFT**

(45) Veröffentlichungstag und Bekanntmachung des Hinweises auf die Patenterteilung:
**02.12.2020 Patentblatt 2020/49**

(21) Anmeldenummer: **16725767.4**

(22) Anmeldetag: **25.05.2016**

(51) Int Cl.:
***F28F 27/00*** *(2006.01)*

(86) Internationale Anmeldenummer:
**PCT/EP2016/000869**

(87) Internationale Veröffentlichungsnummer:
**WO 2016/188635 (01.12.2016 Gazette 2016/48)**

(54) **VERFAHREN ZUM BESTIMMEN EINES ZUSTANDS EINER WÄRMETAUSCHEREINRICHTUNG**

METHOD FOR DETERMINING A STATE OF A HEAT EXCHANGER DEVICE

PROCÉDÉ DE DÉTERMINATION D'UN ÉTAT D'UN ÉCHANGEUR DE CHALEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.05.2015 EP 15169745**
**10.12.2015 EP 15003521**

(43) Veröffentlichungstag der Anmeldung:
**25.04.2018 Patentblatt 2018/17**

(73) Patentinhaber: **Linde GmbH**
**82049 Pullach (DE)**

(72) Erfinder:
• **STEINBAUER, Manfred**
**82399 Raisting (DE)**
• **HECHT, Thomas**
**82178 Puchheim (DE)**
• **KERBER, Christiane**
**82343 Pöcking (DE)**
• **HÖLZL, Reinhold**
**82538 Geretsried (DE)**
• **LEHMACHER, Axel**
**82544 Egling-Moosham (DE)**

• **FREKO, Pascal**
**82547 Eurasburg (DE)**
• **THOMAS, Ingo**
**82041 Oberhaching (DE)**
• **WOITALKA, Alexander**
**81369 München (DE)**

(74) Vertreter: **Meilinger, Claudia Sabine et al**
**Linde GmbH**
**Intellectual Property EMEA**
**Dr.-Carl-von-Linde-Straße 6-14**
**82049 Pullach (DE)**

(56) Entgegenhaltungen:
**EP-B1- 1 830 149        DE-A1- 10 360 240**
**DE-A1-102004 048 660        DE-A1-102010 040 029**
**US-A1- 2003 062 149**

• **Myung Jo Jhung: "ASSESSMENT OF THERMAL FATIGUE IN MIXING TEE BY FSI ANALYSIS", Nuclear Engineering and Technology, vol. 45, no. 1, 1 February 2013 (2013-02-01), pages 99-106, XP055576031, ISSN: 1738-5733, DOI: 10.5516/NET.09.2012.026**

**Beschreibung**

Die Erfindung betrifft ein Verfahren zur Bestimmung eines Zustands einer Wärmetauschereinrichtung. Dabei werden zum Beispiel Plattenwärmetauscher betrachtet und ferner Verfahren zur Herstellung eines Wärmetauschers und/oder einer verfahrenstechnischen Anlage vorgeschlagen. Außerdem betrifft die Erfindung ein Verfahren zum Betreiben von Wärmetauschern bzw. Wärmeübertragern oder verfahrenstechnischen Anlagen.

Es ist wünschenswert, die mechanische und thermische Beanspruchung von Elementen in verfahrenstechnischen Anlagen, wie zum Beispiel Luftzerlegungs- oder Gasverflüssigungsanlagen, zu prognostizieren, um deren Lebensdauer, Wartungsanfälligkeit oder Beständigkeit abzuschätzen. Dazu werden Simulationsverfahren benötigt, die den Betrieb der Anlage realistisch nachbilden und Zustandsgrößen der in der Anlage verbauten Elemente bereitstellen. Meist sind diese Simulationsverfahren rechentechnisch äußerst aufwendig oder sie liefern nicht ausreichend präzise Daten.

In der DE 10 2010 040 029 A1 wird eine Abschätzung von thermomechanischen Spannungen in Schichtwärmeübertragern für Brennstoffzellenanwendungen offenbart. Dabei soll mit Hilfe on CFD (Computational Fluid Dynamics) die Temperaturverteilung in Wärmetauscherbauteilen aus bekannten zeitabhängigen Heißgasmassenströmen bestimmt und thermomechanische Schwellwerte für die maximale Beanspruchung/Spannung des Bauteils aufgrund der bauteilinternen Temperaturunterschiede festgelegt werden.

Die US 2003/062149 A1 offenbart Mikrokühlsysteme für elektronische Bauelemente, bei denen Mikrowärmetauscher mit einem Fluid durchströmt werden. Es werden eindimensionale Simulationen der Wärme- und Fluidströmungen entlang der Wärmetauscherkanäle offenbart, wobei Wärmeübergangskoeffizienten aus Navier-Stokes-Gleichungen und Temperaturverteilungen ermittelt werden.

Aus der DE 10 2004 048 660 A1 ist bekannt, mit Hilfe von CFD-Software Temperaturverteilungen und Wärmeübergangskoeffizientenprofile an berippten Oberflächen aus einer Strömungssimulation zu berechnen. Daraus sollen optimierte Rippenprofile abgeleitet werden.

Die DE 2013 60 240 A1 offenbart die Herstellung von Rippen mit Lamellen für Flachrohrwärmeübertrager. Dabei wird angeregt, CFD-Simulationen einzusetzen, um optimale Rippengeometrien, -Dimensionen und -Positionierungen abzuschätzen.

Es ist daher eine Aufgabe der vorliegenden Erfindung, verbesserte Simulationsmöglichkeiten bereitzustellen.

Diese Aufgabe wird durch ein Verfahren mit den Merkmalen des Anspruchs 1 gelöst. Die abhängigen Ansprüche nennen optionale Weiterbildungen.

Demgemäß wird ein Verfahren zum Bestimmen eines Zustands einer Wärmetauschereinrichtung, welche Mittel zum Wärmeübertragen mit Hilfe von Prozessströmen aufweist, vorgeschlagen. Dabei erfolgt eine thermohydraulische Simulation eines oder mehrerer Prozessströme durch eine oder mehrere Passagen in der Wärmetauschereinrichtung zur Bestimmung von Temperatur- und/oder Wärmeübergangskoeffizientenprofilen der Mittel zum Wärmeübertragen. Bei der thermohydraulischen Simulation werden zeitlich veränderliche Temperaturrandbedingungen ermittelt werden, und der Zustand der Wärmetauschereinrichtung wird mit Hilfe eines Finite Elemente Verfahrens (FEM) für eine strukturmechanische Berechnung des Zustands in Abhängigkeit von den veränderlichen Temperaturrandbedingungen bestimmt. Zur thermohydraulischen Simulation wird eine jeweilige Passage mit einem angekoppelten Mittel zum Wärmeübertragen auf ein eindimensionales Modellsystem mit einer Prozessstromeinspeisung, einer Wärmeübertragungsstrecke und einer Prozessstromausspeisung abgebildet, wobei entlang der Wärmeübertragungstrecke ein insbesondere eindimensional ausgedehnter Körper mit einer Wärmekapazität anliegt,und eine jeweilige Passage wird mit Hilfe eindimensionaler Navier-Stokes-Gleichungen beschrieben.

Vorzugsweise können bei der entsprechenden eindimensionalen Simulation Terme eingehen, die beschreiben: eine zeitliche Masseanreicherung des Prozessfluids, einen räumlichen Massetransport des Prozessfluids, eine Reaktionsrate, eine zeitliche Impulsanreicherung des Prozessfluids, einen räumlichen Impulstransport des Prozessfluids, einen räumlichen Druckgradienten, eine räumliche Reibung, Einflüsse der Schwerkraft auf das Prozessfluid, eine zeitliche Energieanreicherung des Prozessfluids, einen räumlichen Enthalpietransport des Prozessfluids, eine Ausdehnungsarbeit des Prozessfluids, Reibungsdissipation und/oder einen Wärmeeintrag oder akustischen Eintrag von außen.

Der oder die Prozessströme können Materialströme sein und insbesondere von Fluidströmen eines jeweiligen Prozessfluids oder durch Energieströme gebildet sein.

Insofern wird bei einer Ausführungsform ein Verfahren zum Bestimmen eines Zustands einer Wärmetauschereinrichtung, welche Mittel zum Wärmeübertragen mit Hilfe von Fluidströmen eines Prozessfluids aufweist, vorgeschlagen, bei dem eine thermohydraulische Simulation der Fluidströme des Prozessfluids durch Passagen in der Wärmetauschereinrichtung zur Bestimmung von Temperatur- und/oder Wärmeübergangskoeffizientenprofilen der Mittel zum Wärmeübertragen erfolgt.

Das Prozessfluid ist insbesondere ein fluides Medium einer kryotechnischen Anlage, wie Flüssigkeiten, verflüssigte Gase oder Gasgemische. Denkbar ist zum Beispiel Wasser, Flüssiggas, verflüssigte Luft oder Luftzerlegungsprodukte.

Der zu bestimmende Zustand der Wärmetauschereinrichtung ist insbesondere ein thermohydraulischer Zustand. Denkbar ist auch die Bestimmung eines Festigkeitszustands.

Der im Plural gebrauchte Begriff "Mittel" ist als Gattungsbezeichnung zu verstehen, sodass nicht zwingend mehrere strukturelle Elemente zum Wärmeübertragen notwendig sind.

Als Wärmetauschereinrichtung gilt üblicherweise eine Einrichtung, die geeignet ist, Wärme von einer ersten zu einer zweiten Seite zu übertragen. Man kann auch von einer Wärmeübertragereinrichtung, die strukturelle Mittel aufweist, sprechen. Streng genommen erfolgt dabei kein "Austausch" von Wärme, vielmehr wird eine Wärmemenge übertragen, weshalb im Folgenden auch von einem Wärmeübertrager gesprochen wird.

Grundsätzlich umfasst der Begriff "Wärmetauscher" im Sinne dieser Beschreibung auch Einrichtungen, die Wärmemengen übertragen bzw. leiten. Insofern kann auch eine sogenannte Heatpipe bzw. ein Wärmerohr als Wärmetauschereinrichtung aufgefasst werden. Auch ein wärmeleitendes Element in einer Anlage, also ein Mittel zum Wärmeübertragen, kann als Wärmetauschereinrichtung verstanden werden.

Als Wärmetauschereinrichtung gilt ferner ein sogenannter Regenerator, bei dem Wärme zunächst - beispielsweise einem ersten Fluid entzogen und - gespeichert wird und die Wärme anschließend - beispielsweise an ein zweites Fluid - abgegeben wird.

In Ausführungsformen ist die Wärmetauschereinrichtung eingerichtet, eine Wärmemenge von einem ersten Fluid auf ein zweites Fluid zu übertragen. Man spricht auch von einem Rekuperator.

Das vorgeschlagene Verfahren bezieht sich dabei allgemeine Einrichtungen, die Wärme übertragen können.

Es erfolgt dabei eine thermohydraulische Bestimmung von Temperaturprofilen in Passagen des Wärmetauschers, die zeitlich variieren können. Diese dynamischen Temperaturprofile werden als Randbedingungen der strukturmechanischen Berechnung benötigt. Diese wird mit Hilfe von Finite Elemente Methoden (FEM) durchgeführt. Die ermittelten Temperaturprofile können dabei an Strukturelementen des Wärmetauschers vorliegen, welche das Prozessfluid leiten. Mann kann jedoch auch von Temperatur- oder Wärmeübergangskoeffizientenprofilen der jeweiligen Prozessfluidströme sprechen.

Bei der thermohydraulischen Simulation werden zeitlich veränderliche Temperaturrandbedingungen und/oder Wärmeübergangskoeffizientenprofile, an den Mitteln zum Wärmeübertragen, ermittelt. In Weiterbildungen des Verfahrens werden ferner Konzentrations- und/oder Dampfanteilprofile des Prozessfluids ermittelt. Durch die Ermittlung der vorgenannten Profile mit Hilfe der thermohydraulischen Simulation, wobei die Profile als Randbedingungen für weitere Bestimmungsverfahren für den Wärmetauscher oder Wärmeübertrager dienen, wird eine zuverlässige Zustandsbestimmung bei reduziertem Rechenaufwand ermöglicht. Im Rahmen der Simulation werden somit thermodynamische Zustände und fluiddynamische Zustände in der Wärmetauschereinrichtung oder einer verfahrenstechnischen Anlage gleichzeitig ermittelt.

Die zeitlich veränderlichen Temperaturrandbedingungen werden in Ausführungsformen mit Hilfe eines Modells für einen Phasenübergang des Prozessfluids, für eine Stofftrennung von Bestandteilen des Prozessfluids bzw. eine Entmischung von Bestandteilen des Prozessfluids, für einen Auffüllvorgang mit dem Prozessfluid und/oder für fluiddynamische Instabilitäten des Prozessfluids ermittelt.

Vorzugsweise werden bei der thermohydraulischen Simulation ein Wärmekapazitätswert und/oder ein Wärmeübertragungswert für den eindimensionalen ausgedehnten Körper schrittweise oder kontinuierlich erhöht, um ein numerisches Konvergieren des eindimensionalen Modellsystems zu gewährleisten.

Erfindungsgemäß erfasst das Verfahren ferner folgende Schritte:

Erfassen mehrerer, vorzugsweise aller, Passagen eines Wärmetauschers und/oder einer verfahrenstechnischen Anlage mit jeweils einem Anfangspunkt und einem Endpunkt, wobei ein jeweiliger Anfangs- oder Endpunkt einer Prozessstromeinspeisung oder einer Prozessstromausspeisung entspricht;

Erfassen von Knoten zwischen den erfassten Passagen, wobei an einem Knoten mehrere Anfangs und/oder Endpunkte zusammenlaufen;

Zuordnen eines eindimensionalen Modells zu jeder erfassten Passage;

Festlegen von Drücken des Prozessfluids an Prozessstromausspeisungen und den Knoten; und

Durchführen einer räumlich und zeitlich diskretisierten computerimplementierten Berechnung der bzw. des eindimensionalen Modells zum Bestimmen der Temperatur- und/oder Wärmeübergangskoeffizientenprofile.

Vorzugsweise wird im Sinne einer Navier-Stokes'schen Beschreibung ein vollständiger ortsaufgelöster thermodynamischer Zustand in einer Dimension simulationstechnisch berücksichtigt. Dass hieß Masse-, Impuls- und Energiebilanzen werden eindimensional betrachtet. Insofern kann man sagen, dass zur thermohydraulischen Simulation eine jeweilige Passage mit Hilfe eindimensionaler Navier-Stokes-Gleichungen beschrieben wird.

Vorzugsweise werden adiabatische Randbedingungen an den Anfangs- und Endpunkten einer beispielsweise von Metallelementen begrenzten Passage bzw. an einer Prozessstromeinspeisung und einer Prozessstromausspeisung am Metall verwendet. Da heißt, es wird angenommen, dass innerhalb des Metalls in Strömungsrichtung des Prozessfluids kein Wärmetransport erfolgt.

Ausführungsformen des Verfahrens dienen einer Prognose für eine Lebensdauer von Teilen einer verfahrenstechnischen Anlage, wie beispielsweise eines Wärmetauschers, unter dem Einfluss von thermischen Veränderungen während des Betriebs der Anlage. Man spricht auch von einer Lebensdauerverbrauchsanalyse. Gemäß einer Variante des Verfahrens wird der Zustand der Wärmetauschereinrichtung als ein Lebensdauerverbrauch in der Art einer Wöhler-Kurve bestimmt, wobei eine Beanspruchung in Abhängigkeit von einer Anzahl von Betriebszyklen der Wärmetauschereinrichtung bestimmt wird.

Die Mittel zum Wärmeübertragen können ein Rohr, eine Platte, ein Trennblech, ein Profilteil, eine Lamelle oder eine Rippe umfassen.

Vorzugsweise berücksichtigt die Simulation einen Joule-Thompson-Effekt des Prozessstroms in den Passagen.

Bei der Durchführung des Verfahrens erfolgt insbesondere eine zeitliche und örtliche Diskretisierung.

Der Zustand der Wärmetauschereinrichtung wird mit Hilfe eines Finite Elemente Verfahrens (FEM) für eine strukturmechanische Berechnung des Zustands in Abhängigkeit von den veränderlichen Temperaturrandbedingungen bestimmt. Dabei können Spannungszustände (örtlich und zeitlich verteilt) der Wärmeübertragereinrichtung bestimmt werden.

Es wird ferner ein Verfahren zum Herstellen einer Anlage oder Wärmetauschereinrichtung vorgeschlagen, wobei strukturelle Parameter der Wärmetauschereinrichtung in Abhängigkeit von einem bestimmten Zustand als Ergebnis des Verfahrens zum Bestimmen eines Zustands der Wärmetauschereinrichtung des herzustellenden Typs festgelegt werden. Dabei ist wenigstens ein struktureller Parameter insbesondere eine Lötstelle, eine Materialdicke oder eine Materialauswahl.

Durch eine vorherige Simulation, beispielsweise bestimmter Betriebssituationen für den Wärmetauscher, und eine entsprechende Zustandsermittlung als Lebensdauerverbrauchsanalyse, kann das Design der Anlage bzw. des Wärmetauschers derart angepasst werden, dass eine verbesserte Lebensdauererwartung eintritt. Beispielsweise können Fins, Längen- oder Breitenangaben, Lagenmuster, Zweiphaseneinspeisungen oder weitere konstruktive Maßnahmen ergriffen werden. Unter Herstellen ist insofern auch zu verstehen, dass bestehende Anlagen mit zum Beispiel verbauten Wärmetauschern verändert werden, um verbesserte simulierte bzw. prognostizierte Lebensdauern zu erreichen. Man kann insofern auch von einem Verfahren zum Umbauen einer Anlage oder Wärmetauschereinrichtung sprechen, wenn aufgrund durchgeführter Simulationen eine Veränderung der Anlage erfolgt.

Weiterhin wird ein Verfahren zum Betreiben einer Anlage oder Wärmetauschereinrichtung vorgeschlagen, wobei Betriebsparameter in Abhängigkeit von einem bestimmten Zustand als Ergebnis des vorgenannten Verfahrens zum Bestimmen eines Zustands der Wärmetauschereinrichtung festgelegt werden, und wobei ein Betriebsparameter insbesondere ein Druck, ein Wartungsintervall oder ein Austauschzeitpunkt von Mitteln zum Wärmeübertragen ist.

Durch eine Simulation, beispielsweise bestimmter Betriebssituationen oder Betriebsverläufe für den Wärmetauscher oder der Anlage, und eine entsprechende Zustandsermittlung als Lebensdauerverbrauchsanalyse, kann das Design oder der Betrieb der Anlage bzw. des Wärmetauschers derart angepasst werden, dass eine verbesserte Lebensdauererwartung eintritt. Die vorgenommene Simulation ermöglicht damit einen optimierten Betrieb von Anlagen, die Wärmetauscher umfassen.

Weiterhin wird ein Computerprogrammprodukt vorgeschlagen, welches auf einer programmgesteuerten Einrichtung die Durchführung des bzw. der wie oben erläuterten Verfahren veranlasst. Denkbar ist zum Beispiel die Durchführung mit Hilfe eines Computers oder eines Leitwartenrechners für eine verfahrenstechnische Anlage. Die Bestimmung des (thermohydraulischen) Zustands des jeweiligen Wärmeübertragers kann in der Art eines Prozesssimulators implementiert sein. Dadurch können, insbesondere modular, Wechselwirkungen des betrachteten Wärmetauschers mit weiteren Anlagenteilen berücksichtigt werden. Der Prozesssimulator kann Teil einer Simulationssoftware sein.

Ein Computerprogrammprodukt, wie z.B. ein Computerprogramm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen.

Das bzw. die Verfahren sind insbesondere software-implementiert, und es wird im Folgenden auch synonym von einer Simulationssoftware und/oder einem Prozesssimulator gesprochen.

Es wird darüberhinaus eine Benutzerschnittstelle für einen solchen Prozesssimulator vorgeschlagen. Die Benutzerschnittstelle umfasst dann eine Anzeigeeinrichtung, die eingerichtet ist, ein Netzwerk von Passagen visuell darzustellen, erste Auswahlmittel zum Auswählen einer dargestellten Passage, zweite Auswahlmittel zum Zuweisen eines eindimensionalen Modells zu einer ausgewählten Passage, und dritte Auswahlmittel zum Zuweisen von Simulationsparametern zu dem der ausgewählten Passage zugewiesenen eindimensionalen Modell, wobei die Benutzerschnittstelle kommunikativ an den Prozesssimulator gekoppelt ist.

Vorzugsweise ist die Anzeigeeinrichtung der Benutzerschnittstelle ferner eingerichtet, mehrere Varianten von eindimensionalen Modellen zur Auswahl anzuzeigen, wobei die Varianten die Berücksichtigung einer zeitlichen Masseanreicherung des Prozessfluids, eines räumlichen Massetransports des Prozessfluids, einer Reaktionsrate, einer zeitliche Impulsanreicherung des Prozessfluids, eines räumlichen Impulstransportes des Prozessfluids, eines räumlichen Druckgradienten, einer räumliche Reibung, von Einflüssen der Schwerkraft auf das Prozessfluid, einer zeitliche Energieanreicherung des Prozessfluids, eines räumlichen Enthalpietransports des Prozessfluids, einer Ausdehnungsarbeit des Prozessfluids, von Reibungsdissipation und/oder eines Wärmeeintrags oder eines akustischen Eintrags von außen für die jeweilige Passage erlauben.

Eine Simulationseinrichtung umfasst dann mindestens einen Prozesssimulator und eine Benutzerschnittstelle, wie zuvor und im Folgenden beschrieben, und die Benutzerschnittstelle übergibt die ausgewählten und zugewiesenen Angaben für die ausgewählten Passagen, die jeweiligen zugewiesenen Varianten eindimensionaler Modelle und die zugewiesenen Simulationsparameter an den Prozesssimulator.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.

Fig. 1 zeigt schematisch und perspektivisch einen Plattenwärmeübertrager von außen mit einigen Anbauten.

Fig. 2 zeigt den Plattenwärmeübertrager aus Figur 1 mit einem teilweise weggelassenen Abdeckblech ohne die Anbauten.

Fig. 3 zeigt schematisch und perspektivisch eine Passage aus dem Plattenwärmeübertrager der Fig. 1 und 2.

Fig. 4 zeigt eine Darstellung für ein Passagenmodell.

Fig. 5 zeigt Diagramme mit möglichen Start-Temperaturverteilungen in einer Passage.

Fig. 6 - 10 zeigen Simulationsergebnisse für verschiedene Ausführungsformen von Wärmeübertragern.

Fig. 11 zeigt ein Ablaufdiagramm für ein Ausführungsbeispiel eines Simulationsverfahrens zum Bestimmen von Zuständen eines Wärmeübertragers.

Fig. 12 zeigt eine schematische Darstellung für ein Ausführungsbeispiel eines Prozesssimulators zum Bestimmen von Zuständen eines Wärmeübertragers.

Fig. 13 zeigt eine schematische Darstellung für ein Ausführungsbeispiel einer Benutzerschnittstelle für einen Prozesssimulator nach Fig. 12.

Fig. 14 zeigt ein Ablaufdiagramm für ein weiteres Ausführungsbeispiel eines Simulationsverfahrens zum Bestimmen von Zuständen eines Wärmeübertragers.

Fig. 15 zeigt ein Ablaufdiagramm für ein Ausführungsbeispiel eines Verfahrens zum Betreiben einer verfahrenstechnischen Anlage.

In den Figuren sind gleiche oder funktionsgleiche Elemente mit denselben Bezugszeichen versehen worden, sofern nichts anderes angegeben ist.

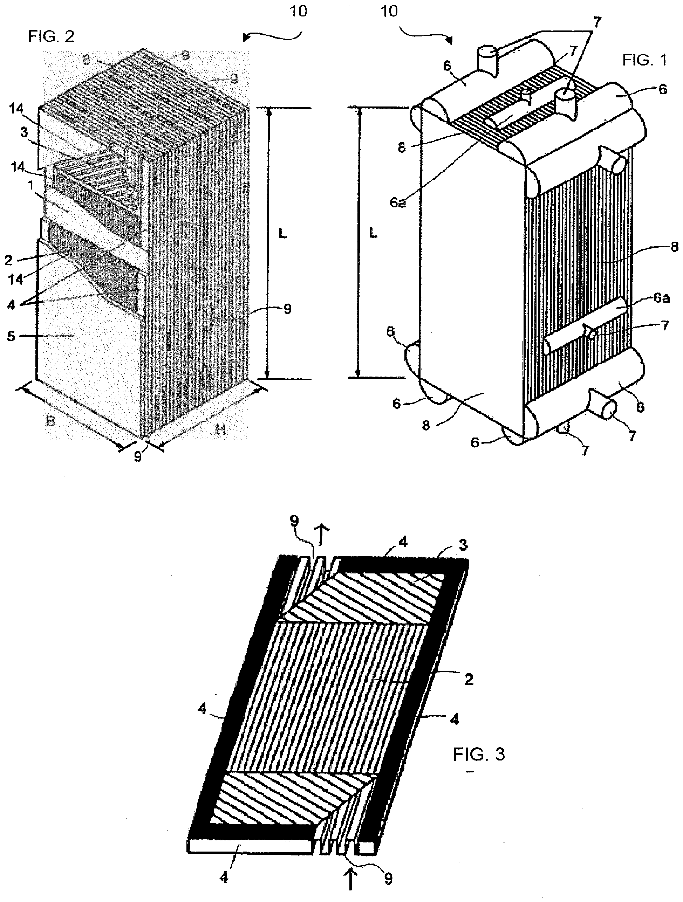

Fig. 1 zeigt als Beispiel für eine Wärmeübertragereinrichtung einen Plattenwärmeübertrager 10 von außen. Der Plattenwärmeübertrager 10 weist einen zentralen Quader 8 mit einer Länge L von etwa 6 m und einer Breite bzw. Höhe B, H von jeweils 1,2 m auf. Oben auf dem Quader 8, an dessen Seiten und unterhalb des Quaders 8 erkennt man Aufsätze 6 und 6a. Unterhalb des Quaders 8 und auf der der abgebildeten Seite abgewandten Seite befinden sich auch solche Aufsätze 6 und 6a. Diese sind jedoch teilweise verdeckt. Durch Stutzen 7 kann dem Plattenwärmeübertrager 10 ein Prozessfluid, zum Beispiel Wasser, zugeführt bzw. diesem wieder entnommen werden. Man erhält beim Durchströmen somit einen Prozessstrom. Die Aufsätze 6 und 6a dienen zur Verteilung des durch die Stutzen 7 eingebrachten Wassers bzw. zum Sammeln und zur Konzentration des aus dem Plattenwärmeübertrager 10 zu entnehmenden Wassers. Innerhalb des Plattenwärmeübertragers 10 tauschen dann die verschiedenen Wasserströme Wärme aus.

Der in Fig. 1 gezeigte Plattenwärmeübertrager 10 ist dazu ausgelegt, mehr als zwei Prozessströme in getrennten Passagen zum Wärmeaustausch aneinander vorbeizuführen. Ein Teil der Ströme kann gegensinnig aneinander vorbeigeführt werden, ein anderer Teil über Kreuz. Zur weiteren Erläuterung wird die vereinfachte Situation betrachtet, dass zwei Prozessströme in getrennten sich abwechselnden Passagen aneinander vorbeiströmen. Grundsätzlich können auch größere Anzahlen von Prozessströmen behandelt werden und im Rahmen einer Simulation berücksichtigt werden.

In Fig. 2 kann man erkennen, wie der Plattenwärmeübertrager 10 im Inneren aufgebaut ist. Im Wesentlichen handelt es sich um einen Quader 8 aus Trennblechen 1 und Einbauten zur Verbesserung des Wärmeübergangs 2, so genannten Fins 2, bzw. Verteilerprofilen 3. Trennbleche 1 und Profile 2 bzw. 3 aufweisende Schichten wechseln sich ab. Eine ein Wärmeaustauschprofil 2 und Verteilerprofile 3 aufweisende Schicht wird Passage 14 genannt (eine solche Passage ist in Fig. 3 gezeigt und wird unten beschrieben).

Der Quader 8 weist also abwechselnd parallel zu den Strömungsrichtungen liegende Passagen 14 und Trennbleche 1 auf. Sowohl die Trennbleche 1 als auch die Passagen 14 sind aus Aluminium gefertigt. Zu ihren Seiten sind die Passagen 14 durch Balken 4 aus Aluminium abgeschlossen, so dass durch die Stapelbauweise mit den Trennblechen 1 eine Seitenwand ausgebildet ist. Die außenliegenden Passagen 14 des Quaders 8 sind durch eine parallel zu den Passagen und den Trennblechen 1 liegende Abdeckung 5 aus Aluminium verdeckt.

Der Quader 8 ist durch Aufbringen eines Lots auf die Flächen der Trennbleche 1 und anschließendes abwechselndes Aufeinanderstapeln der Trennbleche 1 und der Passagen 14 hergestellt. Die Abdeckungen 5 decken den Stapel 8 nach oben oder unten ab. Anschließend ist der Stapel 8 durch Erhitzen in einem den Stapel 8 umfassenden Ofen verlötet worden. Bei der Dimensionierung der Lötstellen oder der Materialdicken können insbesondere Verfahren zum Einsatz kommen, die Festigkeitszustände der Elemente des Wärmeübertragers 10 prognostizieren bzw. berechnen. Bei der Herstellung können dann beispielsweise Schwächen oder besonders stressbelastete Elemente verstärkt werden. Um insbesondere Spannungsverteilungen an den Passagen 14 bestimmen zu können, ist es wünschenswert die aufgrund der Prozessströme auftretenden dynamischen Temperaturverteilungen und/oder -Profile der lokalen Wärmeübergangskoeffizientenprofile zu simulieren.

An den Seiten des Plattenwärmeübertragers 10 weisen die Verteilerprofile 3 Verteilerprofilzugänge 9 auf. Durch diese kann von außen das Wasser als Prozessfluid in die zugehörigen Passagen 14 über die Aufsätze 6 und 6a und Stutzen 7 eingebracht bzw. auch wieder entnommen werden. Die in Figur 2 gezeigten Verteilerprofilzugänge 9 werden in Fig. 1 durch die Aufsätze 6 bzw. 6a verdeckt.

Fig. 3 zeigt eine der Passagen 14 des in den Fig. 1 und 2 gezeigten Plattenwärmeübertragers. Die Strömungsrichtung des Wassers ist durch Pfeile gekennzeichnet. An dem einen Verteilerprofilzugang 9 strömt das Wasser ein, um in dem zugehörigen Verteilerprofil 3 auf die gesamte Breite der Passage 14 verteilt zu werden. Anschließend strömt das Wasser durch das Wärmeaustauschprofil 2 und wird nach erfolgtem Wärmeaustausch von dem anderen Verteilerprofil 3 auf den ausgangsseitigen Verteilerprofilzugang 9 konzentriert. An ihren langen und kurzen Seiten ist die Passage 14 eingegrenzt durch die Balken 4.

Um Verwirbelungen des Wassers zu fördern und damit den Wärmeübergang zu begünstigen, sind in die Wärmeaustauschprofile 2 in dem Beispiel als geschnittene Profile (serrated fins) ausgebildet.

Abhängig von den durch die während des Betriebes durch den Plattenwärmeübertrager 10 fließenden Prozessströme erzeugten Temperaturen vollziehen die Trennbleche 1 und die Profile 2 bzw. 3 thermische Ausdehnungsänderungen. Dies kann zu Thermo-Spannungen führen, welche den Plattenwärmeübertrager 10 ermüden und schließlich beschädigen können.

Durch eine thermohydraulische Simulation der auf diesen Wärmeströmungen basierenden Temperaturverteilung in dem Plattenwärmeübertrager 10 wird die Spannungsverteilung insbesondere mit Hilfe einer strukturmechanischen Berechnung bestimmt. Basierend auf diesen simulierten Spannungsverteilungen lassen sich Ausfallrisiken abschätzen, verbesserte Plattenwärmeübertrager 10 konstruieren und insbesondere auch Betriebsweisen optimieren.

Um die Spannungsverteilung in einem Plattenwärmeübertrager zu bestimmen, wird zunächst die räumliche und zeitliche Temperaturverteilung anhand einer thermohydraulischen Simulation bestimmt und aus dieser die Spannungsverteilung errechnet.

Um die zeitlich veränderlichen Temperaturrandbedingungen, insbesondere an den Mitteln zum Wärmeübertragen, zu ermitteln, erfolgt im Wesentlichen eine Bestimmung der jeweiligen Temperatur- und/oder Wärmeübergangskoeffizientenprofile. Als vereinfachende Annahmen können in Ausführungsformen eindimensionale Navier-Stokes-Gleichungen für die Passagen angenommen werden.

Ferner wird vorzugsweise berücksichtigt: eine Akkumulierung von Energie im Prozessfluid, Dissipation, Korrelationen gemäß HTRI, HTFS, VDI etc. oder Korrelationen, die vom Nutzer der entsprechenden Simulationssoftware definiert werden können, z.B.: $\alpha = \alpha(x(z)), \alpha = \alpha(\dot{m}(z))$ wobei x der Massenanteil an Dampf, z die Position in der Passage und $\dot{m}$ der Massenstrom ist. Ferner kann nach Bedarf die Impulsdynamik berücksichtigt werden.

Zur Energiebilanz wird bei einer vereinfachten Variante des Simulationsverfahrens für die 1-D Wärmekapazität angenommen:

$$\rho c_p \frac{\partial T}{\partial t} + v\rho c_p \frac{\partial T}{\partial z} = \dot{q} \,. \tag{1}$$

Dabei sind $c_p$ die spezifische Wärmekapazität, $\rho$ die Prozessfluiddichte, T die Temperatur, v die Geschwindigkeit des Prozessfluids, z die eindimensionale Position, und $\dot{q}$ ein Wärmeeintrag als Wärmestrom-Liniendichte. Die Gleichung (1) entspricht einem beheizten Rohr oder einer Passage z.B. der Länge L.

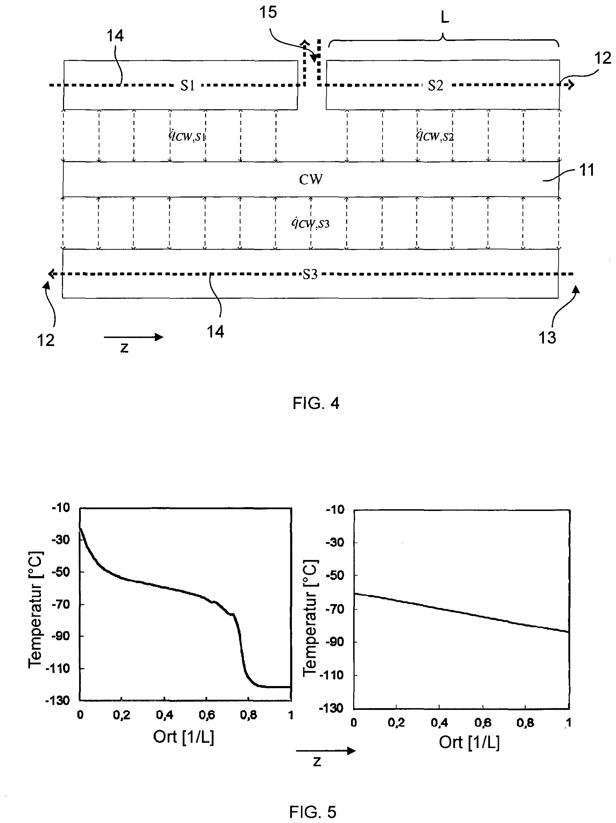

Fig. 4 zeigt ein Beispiel für drei Passagen S1, S2, S3 und einer Trennwand 11 mit einer Wärmekapazität CW. Eine jeweilige Passage, z.B. S3 hat einen Fluideintritt 13 und einen Fluidaustritt 12. Zwischen den Passagen S1, S2, S3 und der Wärmekapazität CW (oder den Wärmekapazitäten) wird die Wärmeübertragung als ein eindimensionales ausgedehntes Wärmestromdichteprofil beschrieben. Um eine Abzweigung beispielsweise in der Art einer Zu- oder Ausspeisung 15 zu simulieren, strömen die beiden Passagen S1 und S2 an der Stelle 15 aus bzw. ein. Für alle Passagen wird eine eindimensionale Modellierung verwendet. Dabei kann die Start-Temperaturverteilung beliebig festgelegt werden. Am Beispiel der Passage S2 ist die Länge L entlang der eindimensionalen Achse z angedeutet. Bezüglich Gleichung (1) wäre der Wärmeeintrag für die Passage S2 mit $\dot{q}CW$, S2 zu bezeichnen.

Es können für die Wärmeleitung der eindimensional angenommenen Trennwand (zum Bespiel aus Metall) adiabatische Randbedingungen verwendet werden, das heißt:

$$\left. \frac{\partial T}{\partial z} \right|_{z=0, z=L} = 0 \,.$$

Insofern werden Temperaturveränderungen in der Trennwand 11 entlang den Strömungsrichtungen der Fluide in den Passagen S1, S2, S3 vernachlässigt. In Varianten des vorgeschlagenen Verfahrens können auch andere Randbedingungen verwendet werden oder ein Wärmetransport in Trennwänden in die Simulation einbezogen werden.

Fig. 5 zeigt zwei Beispiele für eine Anfangstemperaturverteilung in Abhängigkeit von der Position z. Links ist eine Start-Temperaturverteilung gezeigt, die aus einer stationär angenommen Energiebilanz stammt und rechts eine beliebig angenommene Verteilung. Die Anfangsverteilung kann z. B. für eine der Passagen verwendet werden.

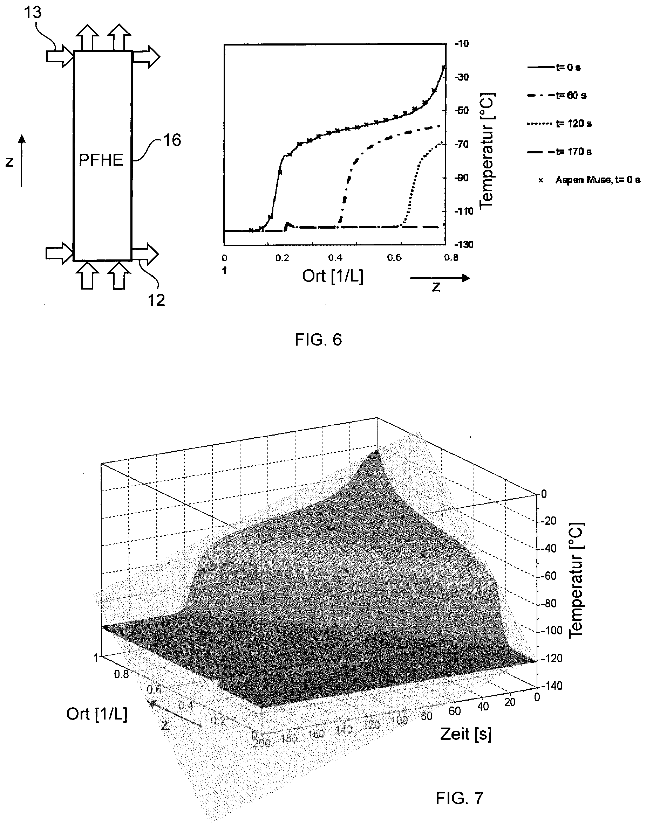

In den folgenden Fig. 6-10 sind Simulationsergebnisse angegeben. Dazu wurde die zu lösenden Differenzialgleichungen der hyperbolischen Erhaltungsgleichung (1) in eine Integralgleichung der folgenden Form überführt:

$$a \frac{\partial \overline{T}}{\partial t} + b\left[F(z^+) - F(z^-)\right] = \overline{\dot{q}(T)} \,, \tag{2}$$

wobei F eine Funktion gemäß dem zweiten Term aus Gleichung (1) ist, a, b entsprechende Vorfaktoren und der hochgestellte Querstrich für das Integralmittel (integraler Mittelwert) gemäß $\bar{f} = f(x^*) = \frac{1}{|\omega|} \int_{\omega} f(x)dx$ steht. Die Stellen $z^+$ und $z^-$ geben die Grenzen des Kontrollvolumens $\omega$ an. Es erfolgt nun eine Diskretisierung im Ortsraum z-Richtung der Passagenlänge L. Aufeinanderfolgende Punkte $z_i$ und $z_{i+1}$ der Diskretisierung bilden den jeweiligen Kontrollraum $z^+$ und $z^-$. Bei der räumlichen Diskretisierung wird für den in eckigen Klammern angegebenen Ausdruck in Gleichung (2) die Erfüllung einer Courant-Friedrichs-Levy-Bedingung verlangt. Man erhält so ein quadratisches Gleichungssystem für Differenzialgleichungen in der Zeit.

Die zeitliche Diskretisierung erfolgt zum Beispiel mit Hilfe eines BDF-Verfahrens (Backward Differentiation Formulae), auf das im Detail hier nicht eingegangen wird. BDF-Verfahren zum Lösen von Differenzialgleichungen sind bekannt.

Die Fig. 6 und 7 zeigen Ergebnisse aus Untersuchungen der Anmelderin für einen sogenannten Aluminium-Brazed Plate Fin Heat Exchanger (PFHE) in dessen Längsrichtung. Im linken Teil von Figur 6 ist die z-Achse vertikal dargestellt. Simuliert wurde ein Szenario, bei dem der warme Prozessfluidstrom (Einspeisung oben links 13, Ausspeisung unten rechts 12) durch den Wärmeübertrager ausfällt. Zum Vergleich der Startbedingungen (t=0 s) sind die Ergebnisse nach dem Stand der Technik gemäß der Simulationssoftware Aspen MUSE aufgetragen. Man erkennt eine gute Übereinstimmung für die Startbedingung. In Fig. 7 ist der zeitliche und örtliche Verlauf der Metalltemperaturen als 3D-Darstellung wiedergegeben.

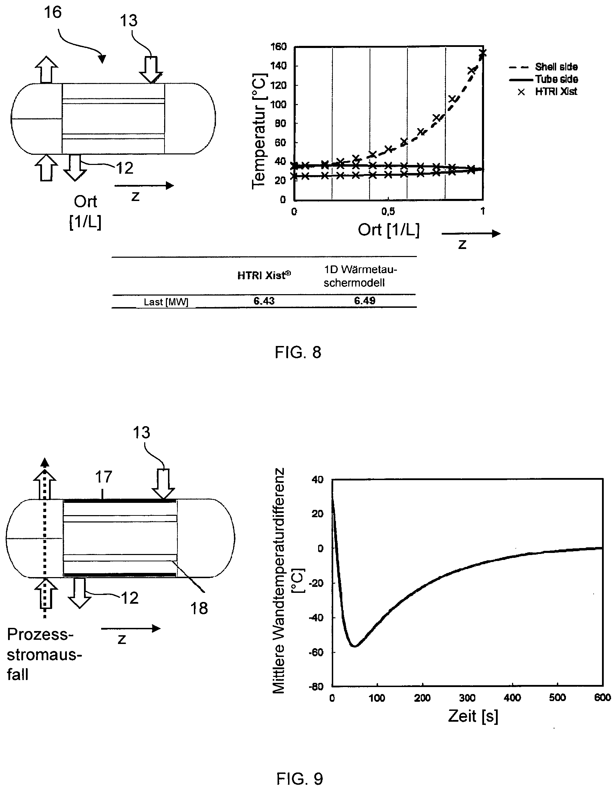

Die Fig. 8 und 9 zeigen Ergebnisse aus Untersuchungen der Anmelderin für einen sogenannten Shell and Tube Heat Exchanger (STHE) 16. In derartigen Wärmeübertragern sind Rohrbündel 18 von einer äußeren Mantelwand 17 umschlossen. Die z-Achse verläuft horizontal, und es wurde ein Szenario simuliert, bei der einer der beiden Prozessströme ausfällt (Fig. 8, Fig. 9). Zum Vergleich sind in Fig. 8 die Temperaturverläufe für t=0 s nach dem Stand der Technik gemäß der Simulationssoftware HTRI Xist aufgetragen. In Fig. 9 zeigt das rechte Diagramm die Temperaturdifferenz zwischen dem Rohrbündel und dem Wärmeübertragermantel nach dem Ausfall des Prozessfluidstroms gemäß der eindimensionalen Modellierung bzw. Simulation.

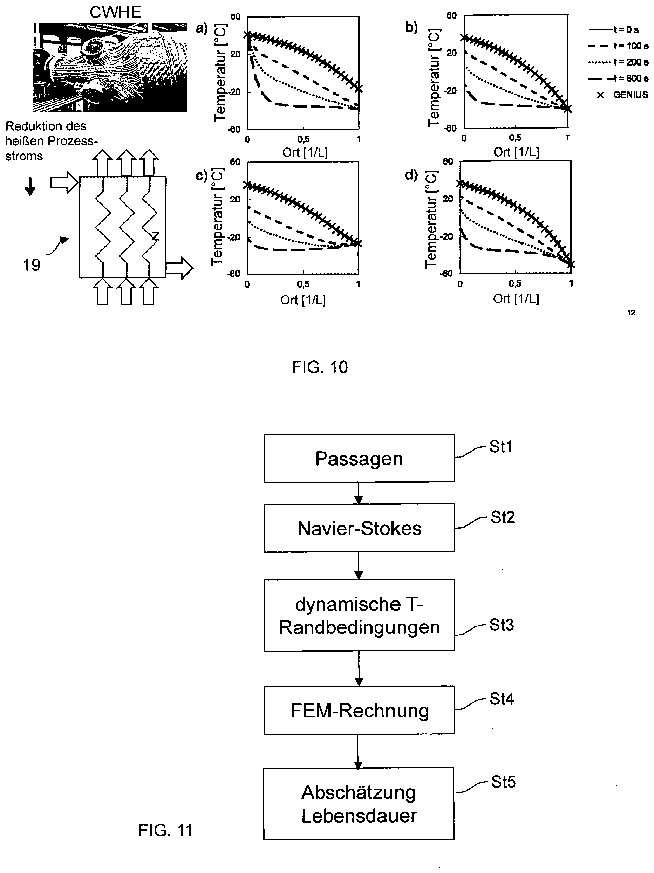

Die Fig. 10 zeigt Ergebnisse aus Untersuchungen der Anmelderin für einen sogenannten Coil Wound Heat Exchanger (CWHE) 19. In derartigen Wärmeübertragern 19 sind gewickelte Rohrbündel von einem äußeren Mantel (shell) umschlossen. Der linke obere Teil von Fig. 10 zeigt ein Bild eines entsprechenden Wärmeübertragers. In Fig. 10 sind die Temperaturverläufe für t=0 s für den warmen Prozessstrom (Mantelseite, (a)) und drei kalte Rohrfraktionen (c)-(d) (durchgezogene Linien) gegen die Ergebnisse der Simulationssoftware GENIUS (x) aufgetragen. Es zeigt sich für den stationären Ausgangszustand eine Übereinstimmung. Des Weiteren ist für drei Zeitpunkte (t = 100 s, 200 s, 800 s) der Temperaturverlauf der drei Prozessströme im gewickelten Wärmeübertrager 19 dargestellt.

Die zeitlichen Temperaturverlaufskurven und Wärmeübergangskoeffizientenprofile können nun als Eingangsdaten für eine strukturmechanische Spannungsanalyse dienen, sodass ein Festigkeitszustand des jeweiligen Wärmeübertragers unter Berücksichtigung thermohydraulischer Eigenschaften ermittelt werden kann.

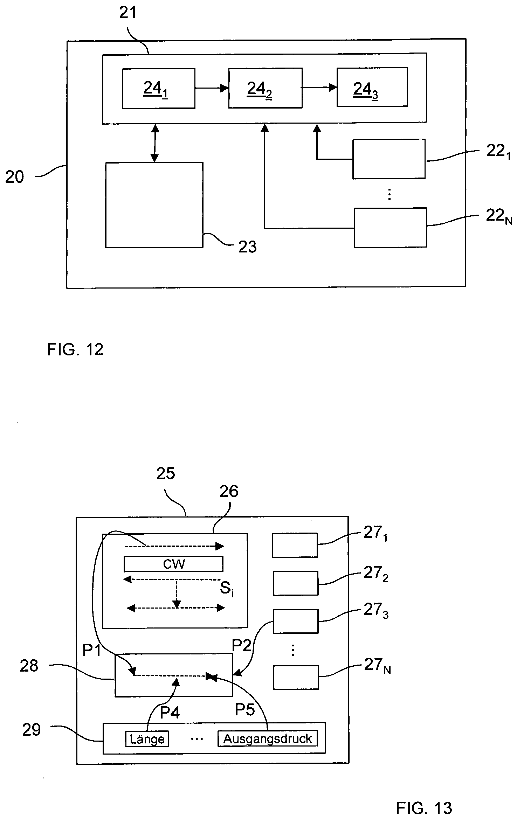

In Fig. 11 sind einige Verfahrensschritte für ein entsprechendes Verfahren zusammengefasst. Das Verfahren wird beispielsweise mit Hilfe eines Prozesssimulators durchgeführt, der als Computerprogramm auf einer rechentechnischen Anlage wie beispielsweise einem PC implementiert sein kann. Die Fig. 12 illustriert ein mögliches Ausführungsbeispiel für einen Prozesssimulator. Zur Bedienung des Prozesssimulators kann eine Benutzerschnittstelle dienen. Ein Beispiel für eine entsprechende Schnittstelle ist ein der Fig. 13 gezeigt. Im Weiteren wird eine Variante des Simulationsverfahrens anhand der Fig. 11 - 13 erläutert.

Der in der Fig. 12 angedeutete Prozesssimulator 20 weist ein Berechnungsmodul 21, mehrere Modellmodule $22_1$ - $22_N$, ein Speichermodul 23 und Simulationsmodule $24_1$ - $24_3$ auf. Die Module 21 - 24 sind zum Beispiel als softwareimplementierte Routinen, Programmteile oder Funktionen ausgeführt. Der Prozesssimulator 20 kann Teil einer Softwarebibliothek sein. Denkbar ist auch eine hardwaremäßige Implementierung, bei der die im Folgenden erläuterten Funktionen der Module oder Einheiten, festverdrahtet, als ASICs oder auch FPGAs implementiert sind.

Zur Bedienung des Prozesssimulators 20 durch eine Bedienperson ist eine in der Fig. 13 angedeutete Benutzerschnittstelle 25 kommunikativ mit dem Prozesssimulator 25 gekoppelt. Die Benutzerschnittstelle 25 und der Prozesssimulator 20 bilden eine Simulationseinrichtung, um Zustände von Wärmeübertragern mit Hilfe einer thermohydraulischen Simulation zu bestimmen.

Die Benutzerschnittstelle 25 umfasst eine Anzeigeeinrichtung 26, die eingerichtet ist, ein Netzwerk von Passagen $S_i$ eines Wärmetauschers visuell darzustellen, erste Auswahlmittel zum Auswählen einer dargestellten Passage, zweite Auswahlmittel zum Zuweisen eines eindimensionalen Modells zu einer ausgewählten Passage, und dritte Auswahlmittel zum Zuweisen von Simulationsparametern zu dem der ausgewählten Passage zugewiesenen eindimensionalen Modell. Die Benutzerschnittstelle 25 zeigt zum Beispiel verschiedene Varianten von eindimensionalen Modellen $27_1$ - $27_N$ zur Auswahl an und ermöglicht ferner, einem jeweiligen ausgewählten Modell für eine Passage einen Satz von Simulationsparameter zuzuweisen, wobei der Prozesssimulator 20 durch das Simulationsmodul $24_1$ dann entsprechende Simulationen durchführt.

Zunächst werden im ersten Schritt St1 die Passagen 14 in der Anlage, wie zum Beispiel in dem Wärmetauscher der Fig. 1 - 3, identifiziert. Die jeweiligen Passagen werden als eindimensionale Systeme mit einem Prozessfluideintritt, einer Wärmeübertragungsstrecke und einem Prozessfluidaustritt abgebildet, wie es in Fig. 4 angedeutet ist. Dazu hat die Benutzerschnittstelle 25 eine Anzeigeeinrichtung 26, die beispielsweise ein Display in der Art eines Monitors oder Touchscreens umfasst. Das Display 26 zeigt ein Netzwerk von Passagen $S_i$ mit jeweils einem Anfangspunkt und einem Endpunkt, möglichen Knoten, an denen mehrere Passagen aneinander anschließen, die Trennwände mit potenziellen Wärmekapazitäten CW und weitere mögliche Elemente der zu betrachtenden verfahrenstechnischen Anlage an. In der Fig. 12 sind vereinfacht Passagen $S_i$ mit gestrichelten Pfeilen angedeutet, wobei Endpunkte oder Ausspeisungen der jeweiligen Pfeilspitze entsprechen.

Der Benutzer kann nun eine Passage Auswählen (vgl. Pfeil P1 in Fig. 13) und ein geeignetes eindimensionales Modell zuordnen. Das Auswählen erfolgt zum Beispiel durch eine Eingabe eines Kommandos oder durch einen Mausklick als Auswahlmittel auf die dargestellte Passage.

Die Benutzerschnittstelle 25 stellt mehrere mögliche Modelle $27_i$ - $27_N$ zu Auswahl. Zum Beispiel kann das in Gleichung (1) angedeutete Modell für ein beheiztes Rohr der ausgewählten Passage zugewiesen werden. Dies ist durch den Pfeil P2 angedeutet.

Anschließend kann der Benutzer Simulationsparameter festlegen, die für die jeweilige ausgewählte Passage gelten. Dazu sind Auswahlmittel 29, beispielsweise anklickbare Schaltflächen vorgesehen. Beispielsweise werden die Länge der Passage und der an der Ausspeisung vorliegende Druck des Prozessfluids festgelegt (Pfeile P4 und P5). Weitere mögliche Simulationsparameter sind zum Beispiel eine Prozessfluidgeschwindigkeit, eine Wärmestrom-Liniendichte, eine Anzahl von Stützstellen entlang der Länge für die räumliche Diskretisierung, eine Fluidtemperatur am Eintritt bzw. der Einspeisung oder eine Wärmekapazität. Weitere Simulationsparameter sind denkbar, wobei die zuzuordnenden Größen von dem gewählten eindimensionalen Modell abhängen.

Der Prozesssimulator 20 verfügt über entsprechende Modellmodule $22_1$ - $22_N$, wobei ein Modellmodul $22_i$ eingerichtet ist, unter Berücksichtigung von zugehörigen Simulationsparametern eine eindimensionale, räumlich und zeitlich unabhängig voneinander erfolgende diskrete numerische Berechnung gemäß dem Modell "i" durchzuführen. Die über die Benutzerschnittstelle 25 auswählbaren eindimensionalen Modelle $27_1$ - $27_N$ werden insofern von den Modellmodulen $22_1$ - $22_N$ rechentechnisch implementiert.

Die Benutzerschnittstelle 25 übergibt nun die jeweilige Modellauswahl zusammen mit den zugehörigen festgelegten Simulationsparametern für die Passagen an den Prozesssimulator 20. Es kann dazu beispielsweise eine Beschreibungssprache oder ein Skript ähnlich eines VHDL-Kodes verwendet werden. Die festgelegten Simulationsparameter werden in dem Speichermodul 23 abgespeichert und können von dem Berechnungsmodul 21 angerufen werden.

Im Schritt St2 (Fig. 11) erfolgt nun eine Simulation der Prozessfluidströmung und der Temperaturverteilung auf der Basis von Navier-Stokes Gleichungen. Im Prozesssimulator 20 greift das Simulationsmodul $24_1$ auf die Modellmodule $22_1$ - $22_N$ und die im Speichermodul 23 vorliegenden Simulationsparameter zu und vollzieht die jeweiligen numerischen Berechnungen. Als Ergebnis werden im Schritt St3 dynamische Temperaturverteilungen an den Oberflächen der Wärmetauscherelemente, wie Platten, Rohren, Aufsätzen, Trennblechen etc. erhalten.

Bei der Simulation im Schritt St2 gehen vorzugsweise Terme ein, die eine zeitliche Masseanreicherung des Prozessfluids, einen räumlichen Massetransport des Prozessfluids, eine Reaktionsrate, eine zeitliche Impulsanreicherung des Prozessfluids, einen räumlichen Impulstransport des Prozessfluids, einen räumlichen Druckgradienten, eine positionsabhängige Reibung, Einflüsse der Schwerkraft auf das Prozessfluid, eine zeitliche Enthalpieanreicherung des Prozessfluids, einen räumlichen Enthalpietransport des Prozessfluids, eine Ausdehnungsarbeit des Prozessfluids, Reibungsdissipation, und/oder einen Wärmeeintrag von außen beschreiben. Dazu werden im Prozesssimulator 20 entsprechende Modellmodule $22_1$ - $22_1$, beispielsweise als Simulationsroutinen, vorgehalten, die von dem (ersten) Simulationsmodul $24_1$ abruf- und nutzbar sind. Es werden dabei jeweils eindimensionale Erhaltungsgleichungen (insbesondere für Masse, Impuls und Energie) und thermodynamische Zustandsgleichungen (insbesondere für Dichte, Temperatur, Druck und Energie) angesetzt.

Man kann für kompressible Fluide die Navier-Stokes-Gleichungen, wie folgt zusammenfassen:

$$\frac{\partial}{\partial t} c_j + \frac{\partial}{\partial z}(c_j u) = \dot{r}_j \ \text{ mit } j = 1, \ldots nc \qquad (3)$$

$$\frac{\partial}{\partial t}(\rho u) + \frac{\partial}{\partial z}(\rho u^2) = -\frac{\partial}{\partial z}p + \frac{\partial}{\partial z}\sigma + \rho g \sin(\Theta) \qquad (4)$$

$$\frac{\partial}{\partial t}(\rho e) + \frac{\partial}{\partial z}(\rho e u) = -p\frac{\partial}{\partial z}u + \sigma\frac{\partial}{\partial z}u + \frac{U}{A_c}\dot{q} \qquad (5)$$

Dabei ist $c_j = n_j/V$ die molare Dichte in mol/m$^3$ für den Fluidbestandteil j, nc die Anzahl der Fluidkomponenten (dimensionslos), $\rho$ die Dichte in kg/m$^3$, u die Geschwindigkeit in m/s, e die spezifische innere Energie in J/kg, pe die Energiedichte in J/m$^3$, $\Theta$ der Angriffswinkel in rad, $\rho \cdot g \cdot \sin(\Theta)$ die hydrostatische Spannung in Pa/m, $\sigma$ der Reibungstensor in N/m$^2$, p der Druck in Pa, $\dot{q}$ die Wärmeflussdicht in W/m$^2$, A die Querschnittsfläche in m$^2$ und U der Umfang. Die Dichte, Geschwindigkeit etc. sind dabei auf das Prozessfluid als Ganzes bezogen. Insofern ist die Dichte $\rho$ zum Beispiel die Mischdichte des gesamten strömenden Fluids mit seinen Bestandteilen.

Die Größen können prinzipiell auch für jeden Fluidbestandteil j angegeben werden und der Simulation zugrunde gelegt werden. Beispielsweise kann so auch eine Entmischung der Komponenten bzw. Bestandteile des jeweiligen Prozessfluids erfasst werden.

Dabei steht der erste Term in der Massenerhaltungsgleichung (3) für eine Massenanreicherung, der zweite für einen Massentransport, und die rechte Seite entspricht der Reaktionsrate. In der Impulserhaltungsgleichung (4) steht der erste Term auf der linken Seite für eine Impulsanreicherung, der zweite für einen Impulstransport. Auf der rechten Seite der Gleichung (4) berücksichtigt der erste Term eine Beschleunigung wegen eines Druckgefälles, der zweite Term Reibung und der Dritte Term Schwerkraftseinflüsse. Die in den Modellgleichungen angegebenen Größen können insbesondere als Simulationsparameter verwendet werden.

Je nach gewünschter Genauigkeit der Simulation aber auch unter Berücksichtigung des Rechenaufwandes können einige der Terme vernachlässigt werden. Es wird insbesondere auch angenommen, dass das Prozessfluid homogen ist, bzw. Dampf (vap) und die Flüssigkeit (liq) mit derselben Geschwindigkeit fließen:

$$\rho = \rho_{vap}\varepsilon + \rho_{liq}(1-\varepsilon), \qquad\qquad (6)$$

wobei $\varepsilon$ der volumetrische Dampfanteil ist.

Es wird zum Beispiel bei der Lösung der Gleichungen unabhängig voneinander zeitlich diskretisiert und räumlich diskretisiert. Dadurch kann der entstehende Rechenaufwand reduziert werden. In Zeitrichtung wird vorzugsweise ein BDF-Verfahren zur numerischen Lösung eingesetzt. Örtlich kann ein Finite Volumen Verfahren verwendet werden.

Beim Starten der Simulation durch den Prozesssimulator 20 werden Wärmekapazitätswerte und/oder ein Wärmeübertragungswert für den eindimensionalen ausgedehnten Körper zunächst nicht berücksichtigt und nur langsam schrittweise oder kontinuierlich erhöht, um ein numerisches Konvergieren des eindimensionalen Modellsystems, welches mit Hilfe der Modellmodule $22_1$ - $22_N$ realisiert wird, zu gewährleisten. Das heißt, es wird von einem nichtwärmegekoppelten Modellsystem gestartet, und der Wärmetransport wird bis zu dem gewünschten Wert gemäß dem jeweiligen Simulationsparameter hochgefahren.

Gegenüber üblichen CFD-Verfahren (computional fluid dynamics) ist der Aufwand wegen der Vereinfachung auf eindimensionale Phänomene stark reduziert. Es kann aufwandsgünstig eine Simulation erfolgen, die zuverlässige Werte liefert.

Die im Schritt St3 durch das Simulationsmodul $24_1$ bereitgestellten Randbedingungen dienen nun der weiteren Berechnungen und Simulation von strukturmechanischen Eigenschaften der im Wärmetauscher verbauten Mittel zur Wärmeübertragung. Man erhält somit Temperatur- und/oder Wärmeübergangskoeffizientenprofile der Mittel zum Wärmeübertragen, welche in nachfolgenden FEM-Rechnungen zugrunde gelegt werden können (Schritt St4).

Das zweite Simulationsmodul $24_2$ des Prozesssimulators 20 ist eingerichtet, ein entsprechendes FEM-Verfahren durchzuführen. Beispielsweise führt das zweite Simulationsmodul $24_2$ ein Verfahren gemäß der EP 1 830 149 B1 durch, auf welche hiermit vollinhaltlich Bezug genommen wird (incorporated by reference).

Bei der strukturmechanischen Bestimmung von temperaturinduzierten Spannungen bzw. der Festigkeit eines Wärmeübertragers können die folgenden Verfahrensschritte durchgeführt werden, wobei zur Vereinfachung ein Plattenwärmetauschers 10 mit Trennblechen 1 und Profilen 2 (vgl. Fig. 1) betrachtet wird:

> Berechnen von Temperaturspannungen des Plattenwärmetauschers 10 im Inneren des Wärmetauschers während dessen Betriebs mittels einer dreidimensionalen numerischen Simulation; und
> Bestimmen der Festigkeit des Plattenwärmetauschers auf der Basis der berechneten Temperaturspannungen.

Bei der dreidimensionalen numerischen Simulation der Temperaturspannungen wird die räumliche Temperaturverteilung in den Profilen 2 und in den Trennblechen 1 bestimmt, indem ein Schichtmodell eines Teiles eines der Profile 2 im Kontakt mit einem der Trennbleche 1 erstellt und verwendet wird. Die dreidimensionale numerische Simulation umfasst dann die Schritte:

> Modellieren des Profilteiles 2 als ein den Raum zwischen den Trennblechen 1 homogen ausfüllender Metallblock, welcher sich an einer seiner Seiten in einem wärmeleitfähigen Kontakt mit dem Trennblech 1 befindet;
> Bestimmen des über das Prozessfluid vermittelten Gesamtwärmeeintrages in das Profilteil 2 und in das angrenzende Trennblech 1 mit einem Wärmeeintrag von dem Fluid in das Profilteil 2 mit anschließender Wärmeleitung durch das Profilteil 2 und von dem Profilteil 2 in das angrenzende Trennblech 1; und
> Einbringen einer dem ersten Wärmeeintrag entsprechenden Wärmemenge in eine erste Fläche innerhalb des Metallblocks. Das Verfahren weist insbesondere Korrekturfaktoren zur Anpassung des Schichtmodells.

Beispielsweise ergeben die FEM-Rechnungen Stress-Kurven, Daten über Vergleichsspannungen oder ähnliche zustandsbestimmenden Größen, die einer Abschätzung für die Lebensdauer bestimmter Elemente im Wärmetauscher dienen können.

Im optionalen Schritt St5 wird daher eine Lebensdauer, beispielsweise von einem Blech im Wärmetauscher bestimmt. Das dritte Simulationsmodul $24_3$ ist dazu eingerichtet, in Abhängigkeit von der strukturmechanischen Bestimmung von temperaturinduzierten Spannungen einen Lebensdauerverbrauch der Anlage bzw. des Wärmetauschers zu berechnen. Ein entsprechendes Simulationssystem, wie der Prozesssimulator 20, basiert somit auf der Verknüpfung der thermo-fluiddynamischen Simulation mit einer Finiten-Elemente-Analyse und Lebensdauerabschätzung.

Eine Finite-Elemente-Analyse zur Lebensdauerabschätzung, wie es in den Schritten St4 und St5 bzw. durch die Simulationsmodule $24_2$ und $24_3$, erfolgt, ist zum Beispiel in R. Hölzl: "Lifetime estimation of aluminum plate fin heat exchangers", Proceedings of the ASME 2012 Pressure Vessels & Piping Division Conference (PVP2012), July 15-19, 2012, Toronto, Ontario, Canada [PVP2012-78343] erläutert, worauf hier vollinhaltlich Bezug genommen wird (incorporated by reference).

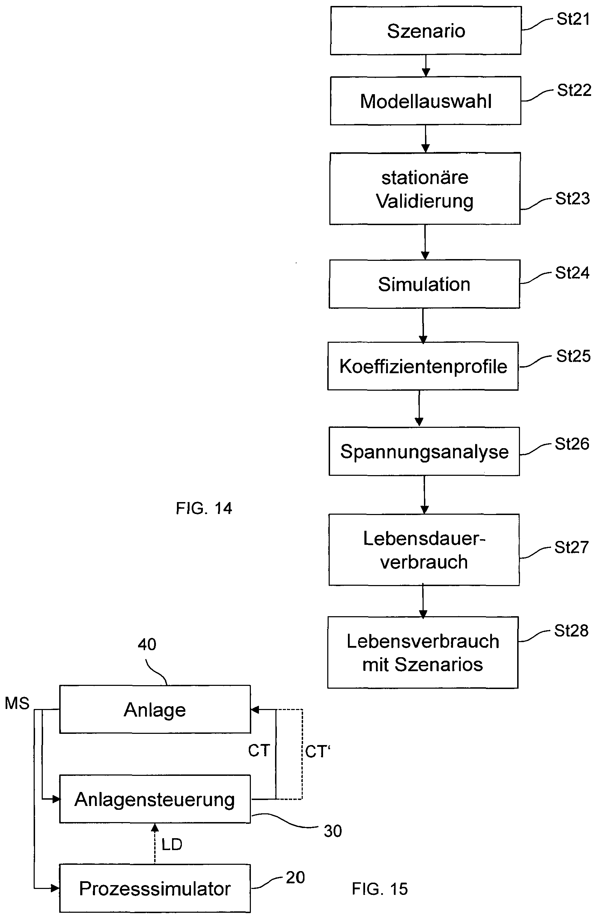

In Fig. 14 ist ein Ablaufdiagramm für ein weiteres Ausführungsbeispiel eines erweiterten Simulationsverfahrens zum Bestimmen von Zuständen eines Wärmeübertragers dargestellt.

Im Schritt St21 werden im Hinblick auf thermische Spannungen und damit auf die erwartbare Lebensdauer des Wärmeübertragers kritische Betriebsszenarien identifiziert und definiert. Zum Beispiel können Anfahr- oder Shutdown-Szenarien bestimmt werden.

Im Schritt St22 bis St24 erfolgt auf Basis der Szenario-Definition die thermohydraulische Modellierung, Validierung und Simulation des/der entsprechenden Wärmeübertrager(s). Die bei der Simulation berücksichtigten Effekte entsprechen denen, die zu den Schritten St2, St3 oben erläutert wurden.

Im Schritt St25 werden als Ergebnis der Simulationen dynamische Temperatur- und Wärmeübergangskoeffizientenprofile erstellt. Diese stellen die Eingangsdaten für die nachfolgenden strukturmechanischen Berechnungen dar, welche in Schritt St26 durchgeführt werden. Die strukturmechanischen Berechnungen liefern zum Beispiel Ermüdungskurven für die berechneten Betriebsszenarien, woraus die zu erwartenden Lebensdauerverbräuche für die einzelnen Szenarien (Schritt St27) ermittelt werden. In der Folge kann für die Gesamtheit der definierten Betriebsszenarien der sich daraus ergebende gesamte Lebensdauerverbrauch für den betrachteten Wärmtauscher bestimmt werden (Schritt St28).

Die Simulationsergebnisse der vorgenannten Analysen können benutzt werden, um eine hinreichende Langlebigkeit von Wärmeübertragern durch Anpassungen zu erreichen. Die Erkenntnisse können zu einem veränderten Design eines Wärmeübertragers, zu veränderten oder optimierten Regelkonzepten der Anlage, zu besonderen Betriebsanweisungen für das Bedienpersonal, zur Implementierung von Alarmen oder zusätzlichen oder veränderten prozesstechnischen Schaltungen führen.

Die Fig. 15 zeigt schematisch eine Anwendung eines Prozesssimulators 20 zur Unterstützung einer Anlagensteuerung 30 bei einem Verfahren zum Betreiben einer verfahrenstechnischen Anlage 40. Üblicherweise steuert die Anlagensteuerung 30 mit Hilfe von Steuersignalen CT die Anlage, wie zum Beispiel eine kryotechnische Anlage zur Luftzerlegung, Gasverflüssigung oder dergleichen. Die Anlagensteuerung 30 erhält Mess- oder Sensorsignale MS von Messsensoren in der Anlage. Zum Beispiel werden Temperaturen, Drücke und Durchflüsse erfasst und von der Anlagensteuerung 30 ausgewertet, damit vorgesehene Betriebsabläufe eingestellt werden können.

In Fig. 15 ist ferner ein Prozesssimulator 20 vorgesehen, der eine Simulation der vollzogenen Betriebsabläufe oder Abwandlungen der geplanten Betriebsabläufe durchführt. Wie zu Fig. 11 erläutert, erfolgt eine Lebensdauerverbrauchsabschätzung (vgl. Schritt St5), sodass ein Betriebsablauf oder ein Betriebsparameter von der Anlagensteuerung 30 derart verändert werden kann, dass eine verbesserte oder verlängerte Betriebsdauer, beispielsweise mit einem verlängerten Wartungsintervall, ermöglicht werden. Dazu liefert der Prozesssimulator 20 Lebensdauerabschätzungen LD an die Anlagensteuerung 30 oder Bedienpersonal. Im Rahmen eines Wartungszyklus kann der weitere Betrieb mit den verbesserten Betriebsparametern oder dem verbesserten Betriebsablauf erfolgen, Die Anlagensteuerung 30 gibt dann gegebenenfalls geänderte Steuersignale CT' aus. Folglich wird der Betrieb der Anlage 40 in Abhängigkeit von der Simulation durch den Prozesssimulator 20 optimiert.

Der Prozesssimulator 20 kann beispielsweise in den Wartungsintervallen Hinweise für zu verändernde Betriebsempfehlungen für das Bedienpersonal geben, Es jedoch auch denkbar, dass aufgrund der Simulationsergebnisse LD die Anlagensteuerung 30 selbsttätig Anpassungen an den jeweiligen Betriebsablauf oder an den Betriebsparametern vornimmt.

Insofern können eine Herstellung, eine Planung, ein Entwurf, ein Umbau oder ein Betreiben einer verfahrenstechnischen Anlage in Abhängigkeit von der thermohydraulischen Simulation, wie es zuvor beschrieben wurde, erfolgen. Es können auch strukturelle Parameter, wie eine Materialauswahl, Plattendicken, Rohrlängen oder dergleichen vor der Herstellung der Anlage oder des Wärmetauschers bestimmt werden.

Obwohl die vorliegende Erfindung anhand von Ausführungsbeispielen beschrieben wurde, ist sie vielfältig modifizierbar. Es können z. B. Wärmeübertrager betrachtet werden, die andere als die dargestellten Geometrien aufweisen.

Verwendete Bezugszeichen:

| | |
|---|---|
| 1 | Trennblech |
| 2 | Wärmeaustauschprofil |
| 3 | Verteilerprofil |
| 4 | Balken |
| 5 | Abdeckung |
| 6, 6a | Aufsatz |
| 7 | Stutzen |
| 8 | zentraler Quader/Stapel |

| 9 | Verteilerprofilzugang |
|---|---|
| 10 | Plattenwärmetauscher |
| 11 | Trennwand |
| 12 | Austritt/Ausspeisung |
| 13 | Eintritt/Zuspeisung |
| 14 | Passage |
| 15 | Abzweig/Ausspeisung |
| 16 | PFHE-Wärmeübertrager |
| 17 | Mantel |
| 18 | Rohre |
| 19 | STHE-Wärmeübertrager |
| 20 | Prozesssimulator |
| 21 | Berechnungsmodul |
| $22_1 - 22_N$ | Modellmodul |
| 23 | Speichermodul |
| $24_1 - 24_3$ | Simulationsmodul |
| 25 | Benutzerschnittstelle |
| 30 | Anlagensteuerung |
| 40 | verfahrenstechnische Anlage |

| CT | Steuersignale |
|---|---|
| CW | Wärmekapazität |
| MS | Messdaten |
| LD | Simulationsergebnis |
| S1 - S3 | Passage |
| St1 - St28 | Verfahrensschritt |

**Patentansprüche**

1. Verfahren zum Bestimmen eines Zustands einer Wärmetauschereinrichtung (10), welche Mittel zum Wärmeübertragen mit Hilfe von mindestens einem Prozessstrom aufweist,

  a) wobei eine thermohydraulische Simulation des mindestens einen Prozessstroms durch mindestens eine Passage (14) in der Wärmetauschereinrichtung (10) zur Bestimmung von Temperatur- und/oder Wärmeübergangskoeffizientenprofilen der Mittel zum Wärmeübertragen erfolgt,
  b) wobei bei der thermohydraulischen Simulation zeitlich veränderliche Temperaturrandbedingungen ermittelt werden; und
  c) wobei der Zustand der Wärmetauschereinrichtung (10) mit Hilfe eines Finite Elemente Verfahrens (FEM) für eine strukturmechanische Berechnung des Zustands in Abhängigkeit von den veränderlichen Temperaturrandbedingungen bestimmt wird;
  d) wobei zur thermohydraulischen Simulation eine jeweilige Passage (14) mit einem angekoppelten Mittel zum Wärmeübertragen auf ein eindimensionales Modellsystem mit einer Prozessstromeinspeisung (13), einer Wärmeübertragungsstrecke (S3) und einer Prozessstromausspeisung (12) abgebildet wird, wobei entlang der Wärmeübertragungstrecke (S3) ein eindimensional ausgedehnter Körper (11) mit einer Wärmekapazität (CW) anliegt,
  e) wobei zur thermohydraulischen Simulation eine jeweilige Passage (14) mit Hilfe eindimensionaler Navier-Stokes-Gleichungen beschrieben wird; und

  wobei das Verfahren ferner die Schritte umfasst:

  Erfassen mehrerer Passagen der Wärmetauschereinrichtung (10) mit jeweils einem Anfangspunkt und einem Endpunkt, wobei ein jeweiliger Anfangs- oder Endpunkt einer Prozessstromeinspeisung oder einer Prozessstromausspeisung entspricht;
  Erfassen von Knoten zwischen den erfassten Passagen (14), wobei an einem Knoten mehrere Anfangs- und/oder Endpunkte zusammenlaufen;
  Zuordnen eines eindimensionalen Modells zu jeder erfassten Passage (14);
  Festlegen von Drücken des Prozessfluids an Prozesstromausspeisungen und den Knoten; und

Durchführen einer räumlich und zeitlich diskretisierten computerimplementierten Berechnung des jeweiligen eindimensionalen Modells zum Bestimmen der Temperatur- und/oder Wärmeübergangskoeffizientenprofile.

2.  Verfahren nach Anspruch 1, wobei der mindestens eine Prozessstrom einen Materialstrom, insbesondere eines Fluidstroms eines jeweiligen Prozessfluids, oder einen Energiestrom aufweist.

3.  Verfahren nach Anspruch 1 oder 2, wobei bei der thermohydraulischen Simulation zeitlich veränderliche Wärmeübergangskoeffizientenprofile an den Mitteln zum Wärmeübertragen, ermittelt werden.

4.  Verfahren nach Anspruch 3, wobei die zeitlich veränderlichen Temperaturrandbedingungen mit Hilfe eines Modells für einen Phasenübergang des Prozessfluids, für eine Stofftrennung von Bestandteilen des Prozessfluids, für einen Auffüllvorgang mit dem Prozessfluid und/oder für fluiddynamische Instabilitäten des Prozessfluids ermittelt werden.

5.  Verfahren nach einem der Ansprüche 1 - 4, wobei ein Wärmekapazitätswert und/oder ein Wärmeübertragungswert für den eindimensionalen ausgedehnten Körper (11) schrittweise oder kontinuierlich erhöht, um ein numerisches Konvergieren des eindimensionalen Modellsystems zu gewährleisten.

6.  Verfahren nach einem der Ansprüche 1 - 5, wobei die eindimensionalen Navier-Stokes-Gleichungen unabhängig voneinander zeitlich diskretisiert und räumlich diskretisiert werden.

7.  Verfahren nach Anspruch 1 - 6, wobei jeweils eindimensionale Erhaltungsgleichungen für eine Masse, einen Impuls und eine Energie angesetzt werden und thermodynamische Zustandsgleichungen für eine Dichte, eine Temperatur, einen Druck und die Energie angesetzt werden.

8.  Verfahren nach einem der Ansprüche 1 - 7, wobei in die eindimensionale Simulation Terme eingehen, die beschreiben: eine zeitliche Masseanreicherung des Prozessfluids, einen räumlichen Massetransport des Prozessfluids, eine Reaktionsrate, eine zeitliche Impulsanreicherung des Prozessfluids, einen räumlichen Impulstransport des Prozessfluids, einen räumlichen Druckgradienten, eine räumliche Reibung, Einflüsse der Schwerkraft auf das Prozessfluid, eine zeitliche Energieanreicherung des Prozessfluids, einen räumlichen Enthalpietransport des Prozessfluids, eine Ausdehnungsarbeit des Prozessfluids, Reibungsdissipation, und/oder einen Wärmeeintrag von außen. Durchführen einer räumlich und zeitlich diskretisierten computerimplementierten Berechnung des jeweiligen eindimensionalen Modells zum Bestimmen der Temperatur- und/oder Wärmeübergangskoeffizientenprofile.

9.  Verfahren nach einem der Ansprüche 1 - 8, wobei der Zustand der Wärmetauschereinrichtung (10) als ein Lebensdauerverbrauch in der Art einer Wöhler-Kurve bestimmt wird, wobei eine Beanspruchung in Abhängigkeit von einer Anzahl von Betriebszyklen der Wärmetauschereinrichtung (10) bestimmt wird.

10.  Verfahren nach einem der Ansprüche 1 - 9, wobei die Mittel zum Wärmeübertragen ein Rohr, eine Platte, ein Trennblech, ein Profilteil, eine Lamelle, eine Rippe oder eine Einrichtung zum Wärmespeichern umfassen.

11.  Verfahren nach einem der Ansprüche 1 - 10, wobei die Simulation einen Joule-Thompson-Effekt des Prozessstroms den Passagen berücksichtigt.

12.  Verfahren nach einem der Ansprüche 1 - 11, wobei örtlich und zeitlich verteilte Spannungszustände der Wärmeübertragereinrichtung (10) bestimmt werden.

13.  Verfahren zum Herstellen einer Wärmetauschereinrichtung (10), wobei strukturelle Parameter der Wärmetauschereinrichtung (10) in Abhängigkeit von einem bestimmten Zustand als Ergebnis des Verfahrens nach einem der Ansprüche 1 - 12 festgelegt werden, wobei ein struktureller Parameter insbesondere eine Lötstelle, eine Materialdicke oder eine Materialauswahl ist.

14.  Verfahren zum Betreiben einer Wärmetauschereinrichtung (10), wobei Betriebsparameter in Abhängigkeit von einem bestimmten Zustand als Ergebnis des Verfahrens nach einem der Ansprüche 1 - 13 festgelegt werden, wobei ein Betriebsparameter insbesondere ein Druck, ein Wartungsintervall oder ein Austauschzeitpunkt von Mitteln zum Wärmeübertragen ist.

**Claims**

1. Method for determining a state of a heat exchanger device (10) which has means for transferring heat with the aid of at least one process flow,

    a) wherein a thermohydraulic simulation of the at least one process flow is effected by at least one passage (14) in the heat exchanger device (10) for determining temperature and/or heat transfer coefficient profiles of the means for transferring heat,
    b) wherein time-variable temperature boundary conditions are ascertained during the thermohydraulic simulation; and
    c) wherein the state of the heat exchanger device (10) is determined with the aid of a finite element method (FEM) for a structural-mechanical calculation of the state as a function of the variable temperature boundary conditions;
    d) wherein, for the thermohydraulic simulation, a respective passage (14) with a coupled means for transferring heat is mapped onto a one-dimensional model system having a process flow infeed (13), a heat transfer path (S3), and a process flow outfeed (12), wherein a one-dimensionally extended body (11) having a heat capacity (CW) lies along the heat transfer path (S3),
    e) wherein, for the thermohydraulic simulation, a respective passage (14) is described with the aid of one-dimensional Navier-Stokes equations; and
    wherein the method further includes the steps of:

    detecting several passages of the heat exchanger device (10), each having a start point and an end point, wherein a respective start point or end point corresponds to a process flow infeed or a process flow outfeed;
    detecting nodes between the detected passages (14), wherein several start and/or end points converge at a node;
    associating a one-dimensional model with every detected passage (14);
    determining pressures of the process fluid at process flow outfeeds and the nodes; and
    performing a spatially and temporally discretized, computer-implemented calculation of the respective one-dimensional model for determining the temperature and/or heat transfer coefficient profiles.

2. Method according to claim 1, wherein the at least one process flow has a material flow - in particular, a fluid flow of a respective process fluid - or an energy flow.

3. Method according to claim 1 or 2, wherein, in the thermohydraulic simulation, time-variable heat transfer coefficient profiles are determined at the means for transferring heat.

4. Method according to claim 3, wherein the time-variable temperature boundary conditions are determined with the aid of a model for a phase transition of the process fluid, for a material separation of components of the process fluid, for a filling process with the process fluid, and/or for fluid dynamic instabilities of the process fluid.

5. Method according to one of claims 1 - 4, wherein a heat capacity value and/or a heat transfer value for the one-dimensionally expanded body (11) increases stepwise or continuously in order to ensure a numerical convergence of the one-dimensional model system.

6. Method according to one of claims 1 - 5, wherein the one-dimensional Navier-Stokes equations are, independently of one another, chronologically discretized and spatially discretized.

7. Method according to claim 1 - 6, wherein, in each case, one-dimensional maintenance equations are applied for a mass, an impulse, and an energy, and thermodynamic state equations are applied for a density, a temperature, a pressure, and the energy.

8. Method according to one of claims 1 - 7, wherein the one-dimensional simulation involves terms that describe: a temporal mass enrichment of the process fluid, a spatial mass transport of the process fluid, a reaction rate, a temporal impulse enrichment of the process fluid, a spatial impulse transport of the process fluid, a spatial pressure gradient, a spatial friction, influences of gravity on the process fluid, a temporal energy enrichment of the process fluid, a spatial enthalpy transport of the process fluid, an expansion work of the process fluid, frictional dissipation, and/or a heat input from outside.
Performing a spatially and temporally discretized, computer-implemented calculation of the respective one-dimensional model for determining the temperature and/or heat transfer coefficient profiles.

9. Method according to one of claims 1 - 8, wherein the state of the heat exchanger device (10) is determined as a lifetime consumption in the manner of a Wohler curve, wherein a load is determined as a function of a number of operating cycles of the heat exchanger device (10).

10. Method according to one of claims 1 - 9, wherein the means for transferring heat comprise a tube, a plate, a separating sheet, a profiled part, a lamella, a rib, or a device for heat storage.

11. Method according to one of claims 1 - 10, wherein the simulation takes into account a Joule-Thompson effect of the process flow on the passages.

12. Method according to one of claims 1 - 11, wherein spatially and temporally distributed stress states of the heat exchanger device (10) are determined.

13. Method for manufacturing a heat exchanger device (10), wherein structural parameters of the heat exchanger device (10) are determined as a function of a determined state as a result of the method according to one of claims 1 - 12, wherein a structural parameter is, in particular, a solder joint, a material thickness, or a material selection.

14. Method for operating a heat exchanger device (10), wherein operating parameters are determined as a function of a determined state as a result of the method according to one of claims 1 - 13, wherein an operating parameter is, in particular, a pressure, a maintenance interval, or an exchange time point of means for heat transfer.


**Revendications**

1. Procédé pour déterminer un état d'un dispositif d'échange de chaleur (10), qui présente des moyens pour le transfert de chaleur à l'aide d'au moins un courant de processus,

   a) une simulation thermohydraulique dudit au moins un courant de processus à travers au moins un passage (14) dans le dispositif d'échange de chaleur (10) étant réalisée pour déterminer des profils de température et/ou de coefficient de transfert thermique des moyens de transfert de chaleur,
   b) des conditions limites variables dans le temps de température étant déterminées lors de la simulation thermohydraulique ; et
   c) l'état du dispositif d'échange de chaleur (10) étant déterminé à l'aide d'une méthode par éléments finis (MEF) pour un calcul mécanique structural de l'état en fonction des conditions limites variables de température ;
   d) un passage respectif (14) présentant un moyen accouplé pour le transfert de chaleur étant formé, pour la simulation thermohydraulique, sur un système de modèle unidimensionnel présentant une injection de courant de processus (13), une zone de transfert de chaleur (S3) et une sortie de courant de processus (12), un corps (11) allongé dans une dimension, présentant une capacité thermique (CW), étant disposé le long de la zone de transfert de chaleur (S3), e) un passage respectif (14) étant décrit, pour la simulation thermohydraulique, à l'aide d'équations unidimensionnelles de Navier-Stokes ; et
   le procédé comprenant en outre les étapes de :

   détection de plusieurs passages du dispositif d'échange de chaleur (10) présentant à chaque fois un point de départ et un point final, un point de départ ou final respectif correspondant à une injection de courant de processus ou à une sortie de courant de processus ;
   détection de nœuds entre les passages détectés (14), plusieurs points de départ et/ou finaux convergeant au niveau d'un noeud ;
   attribution d'un modèle unidimensionnel à chaque passage détecté (14) ;
   définition de pressions du fluide de processus au niveau des sorties de courant de processus et des nœuds ; et
   réalisation d'un calcul informatique spatialement et temporellement discrétisé du modèle unidimensionnel respectif pour déterminer les profils de température et/ou de coefficient de transfert thermique.

2. Procédé selon la revendication 1, le au moins un courant de processus présentant un courant de matière, en particulier un courant fluidique d'un fluide de processus respectif ou un courant d'énergie.

3. Procédé selon la revendication 1 ou 2, des profils variables dans le temps de coefficient de transfert thermique étant déterminés au niveau des moyens pour le transfert de chaleur lors de la simulation thermohydraulique.

4. Procédé selon la revendication 3, les conditions limites variables dans le temps de température étant déterminées à l'aide d'un modèle pour un transfert de phase du fluide de processus, pour une séparation de substances de constituants du courant de processus, pour une opération de remplissage par le fluide de processus et/ou pour des instabilités d'un point de vue de dynamique des fluides du fluide de processus.

5. Procédé selon l'une quelconque des revendications 1 à 4, une valeur de capacité thermique et/ou une valeur de transfert thermique pour un corps (11) allongé unidimensionnel augmentant par paliers ou en continu pour garantir une convergence numérique du système de modèle unidimensionnel.

6. Procédé selon l'une quelconque des revendications 1 à 5, les équations unidimensionnelles de Navier-Stokes étant discrétisées temporellement et discrétisées spatialement indépendamment les unes des autres.

7. Procédé selon les revendications 1 à 6, des équations unidimensionnelles de conservation pour une masse, une impulsion et une énergie étant établies et des équations thermodynamiques d'état pour une densité, une température, une pression et l'énergie étant établies.

8. Procédé selon l'une quelconque des revendications 1 à 7, des termes, qui décrivent une accumulation temporelle massique du fluide de processus, un transport spatial massique du fluide de processus, un taux de réaction, une accumulation temporelle d'impulsions du fluide de processus, un transport spatial d'impulsions du fluide de processus, un gradient spatial de pression, un frottement spatial, des influences de la gravité sur le fluide de processus, une accumulation temporelle en énergie du fluide de processus, un transport spatial d'enthalpie du fluide de processus, un travail de dilatation du fluide de processus, une dissipation de frottement et/ou un apport thermique de l'extérieur, entrant dans la simulation unidimensionnelle.
réalisation d'un calcul informatique spatialement et temporellement discrétisé du modèle unidimensionnel respectif pour déterminer les profils de température et/ou de coefficient de transfert thermique.

9. Procédé selon l'une quelconque des revendications 1 à 8, l'état du dispositif d'échange de chaleur (10) étant déterminé comme une utilisation sur la durée de vie sous la forme d'une courbe de Wöhler, une sollicitation en fonction d'un nombre de cycles de fonctionnement du dispositif d'échange de chaleur (10) étant déterminée.

10. Procédé selon l'une quelconque des revendications 1 à 9, les moyens pour le transfert de chaleur comprenant un tuyau, une plaque, une tôle de séparation, une pièce profilée, une lamelle, une ailette ou un dispositif pour l'accumulation de chaleur.

11. Procédé selon l'une quelconque des revendications 1 à 10, la simulation tenant compte d'un effet de Joule-Thompson du courant de processus des passages.

12. Procédé selon l'une quelconque des revendications 1 à 11, des états de contrainte répartis localement et temporellement du dispositif de transfert de chaleur (10) étant déterminés.

13. Procédé pour la fabrication d'un dispositif d'échange de chaleur (10), les paramètres structuraux du dispositif d'échange de chaleur (10) étant définis en fonction d'un état déterminé en tant que résultat du procédé selon l'une quelconque des revendications 1 à 12, un paramètre structural étant en particulier une soudure, une épaisseur de matériau ou un choix de matériau.

14. Procédé de fonctionnement d'un dispositif d'échange de chaleur (10), des paramètres de fonctionnement étant définis en fonction d'un état déterminé en tant que résultat du procédé selon l'une quelconque des revendications 1 à 13, un paramètre de fonctionnement étant en particulier une pression, un intervalle d'entretien ou un moment de remplacement de moyens pour le transfert de chaleur.

FIG. 2

FIG. 1

FIG. 3

FIG. 4

FIG. 5

FIG. 6

FIG. 7

| | HTRI Xist® | 1D Wärmetau- schermodell |
|---|---|---|
| Last [MW] | 6.43 | 6.49 |

FIG. 8

FIG. 9

CWHE

Reduktion des
heißen Prozessstroms

19

FIG. 10

FIG. 11

Passagen — St1

Navier-Stokes — St2

dynamische T-
Randbedingungen — St3

FEM-Rechnung — St4

Abschätzung
Lebensdauer — St5

21

24₁ → 24₂ → 24₃

20

22₁

22ₙ

23

FIG. 12

25

26

CW

Sᵢ

27₁

27₂

27₃

27ₙ

28

P1

P2

29

P4

P5

Länge ⋯ Ausgangsdruck

FIG. 13

Szenario — St21

Modellauswahl — St22

stationäre Validierung — St23

Simulation — St24

Koeffizientenprofile — St25

Spannungsanalyse — St26

Lebensdauer-verbrauch — St27

Lebensverbrauch mit Szenarios — St28

FIG. 14

40

MS

Anlage

CT    CT'

Anlagensteuerung — 30

LD

Prozesssimulator — 20

FIG. 15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010040029 A1
- US 20030062149 A1
- DE 102004048660 A1
- DE 201360240 A1
- EP 1830149 B1

**In der Beschreibung aufgeführte Nicht-Patentliteratur**

- **R. HÖLZL.** Lifetime estimation of aluminum plate fin heat exchangers. *Proceedings of the ASME 2012 Pressure Vessels & Piping Division Conference (PVP2012),* 15. Juli 2012